(19)

Europäisches
Patentamt
European
Patent Office
Office européen
des brevets

(11) **EP 2 579 172 A1**

(12) **EUROPEAN PATENT APPLICATION**
published in accordance with Art. 153(4) EPC

(43) Date of publication:
**10.04.2013 Bulletin 2013/15**

(21) Application number: **11789634.0**

(22) Date of filing: **20.05.2011**

(51) Int Cl.:
**G06F 17/50** *(2006.01)* **H02M 1/08** *(2006.01)*

(86) International application number:
**PCT/JP2011/061611**

(87) International publication number:
**WO 2011/152225 (08.12.2011 Gazette 2011/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.06.2010 JP 2010128030**

(71) Applicant: **Hitachi, Ltd.**
**Chiyoda-ku**
**Tokyo 100-8280 (JP)**

(72) Inventors:
• **TSUCHIE Yoshiyuki**
**Tokyo 100-8220 (JP)**

• **TORIGOE Makoto**
**Tokyo 100-8220 (JP)**
• **OSAKA Hideki**
**Tokyo 100-8220 (JP)**
• **SUGA Takashi**
**Tokyo 100-8220 (JP)**

(74) Representative: **Moore, Graeme Patrick et al**
**Mewburn Ellis LLP**
**33 Gutter Lane**
**London**
**EC2V 8AS (GB)**

(54) **DESIGN SUPPORT DEVICE AND DESIGN SUPPORT METHOD OF GATE DRIVE CIRCUIT**

(57) A design support device shortening TAT in designing a gate drive circuit is provided. The device comprises: a circuit analysis unit that calculates a switching voltage of a semiconductor element by using a parameter of the circuit element included in the gate drive circuit that controls switching of the semiconductor element; an electromagnetic field analysis unit that calculates an electromagnetic radiation noise generated in a system, on which the gate drive circuit is mounted, by the switching voltage; a first determination unit that determines whether the electromagnetic radiation noise is at a target value; a first circuit improvement unit that improves a parameter of the circuit element so as to suppress electromagnetic radiation noise where the electromagnetic radiation noise is not at the target value; and a noise estimation unit that estimates the electromagnetic radiation noise based on the switching voltage calculated by the circuit analysis unit by using the improved parameter. A central processing device optimizes the parameter of the circuit element (see Figure 4).

Fig. 4

**Description**

Technical Field

The present invention relates to a design support device and a design support method of a gate drive circuit. For example, the present invention relates to a design support device of a gate drive circuit of a semiconductor element mounted on a power converter and a design support method thereof.

Background Art

Power converters such as inverters and converters, are widely used in consumer electronics devices, information/video equipment, OA/FA devices and transportation apparatuses including railroads and motor vehicles. The power converter generates a desired output power by converting the frequency, the number of phases, the electric voltage and the electrical current of the input power so that loads, including motors, can be controlled.

Power conversion is performed by switching semiconductor elements mounted on a power converter. The circuit that controls switching of the semiconductor element is referred to as a gate drive circuit. When the gate drive circuit switches the semiconductor element, a switching voltage and a switching current rapidly change, and therefore an electromagnetic radiation noise is generated. The electromagnetic radiation noise, by propagating in the whole of the power conversion system including the power converter, a load and an input power supply to interfere with electronic equipment, might cause malfunction of the electronic equipment. Therefore, from the standpoint of ensuring reliability, the electromagnetic radiation noise should be suppressed to a value that does not cause malfunction of other devices. In order to suppress the electromagnetic radiation noise, it is necessary to lower the temporal change rate of the switching voltage and the switching current.

On the other hand, when the temporal change rates of the switching voltage and switching current are lowered, the period by which ON and OFF of the semiconductor element switches becomes long, and therefore the switching loss is increased. The switching loss refers to an electricity consumption defined by a time quadrature of a product of a switching current and a switching voltage. It is desirable that the switching loss is reduced as far as possible from the standpoint of energy conservation because the switching loss deteriorates energy conversion efficiency of the power converter. Further, the power consumed as switching loss becomes heat to raise the temperature of semiconductor elements. Therefore, there is a need to reduce the switching loss also from the standpoint of securing reliability. Further, when the temperature of a semiconductor element becomes too high, thermorunaway is caused. Therefore, it is common that the power converter is mounted on a cooling system. When the switching loss grows, a so powerful cooling system as to address the switching loss becomes necessary. Therefore, it is necessary to reduce the switching loss also from the standpoint of downsizing power converter and avoiding higher cost.

In this way, suppressing the electromagnetic radiation noise and the reduction of the switching loss is generally in the relationship of trade-off. In general, in designing a gate drive circuit, circuit element optimization is performed in consideration of the balance.

Patent Literatures 1-3 disclose a gate drive circuit to reconcile suppressing the electromagnetic radiation noise with the reduction in switching loss in consideration of the trade-off.

Citation List

Patent Literature

Patent Literature 1: JP Patent Publication (Kokai) No. 2009-253699 A (2009)
Patent Literature 2: JP Patent Publication (Kokai) No. 2009-71956 A (2009)
Patent Literature 3: JP Patent Publication (Kokai) No. 2006-230166 A (2006)

Summary of Invention

Technical Problem

However, in order to design gate drive circuits disclosed in above-stated Patent Literatures 1-3, it is necessary to carry out design processes of selecting a parameter of the circuit element, performing an electromagnetic field analysis on an electromagnetic radiation noise generated by switching of the gate drive circuit with the semiconductor element, and if a desired result is not achieved, again performing an electromagnetic field analysis by varying the parameters of the circuit element. In other words, it is necessary to repeat, until a desired result is obtained, electromagnetic field analysis each time a parameter of the circuit element is changed. The electromagnetic field analysis is a complex simulation and requires, a very long time. Therefore, the repetition of the electromagnetic field analysis elongates the Turn Around Time (TAT) of designing as a whole, leading to an increased designing cost.

The present invention is made in view of the above-sated problem, and provides a design support device that shortens TAT in designing a gate drive circuit.

Solution to Problem

In order to overcome the above-stated problem, in the present invention an electromagnetic radiation noise is obtained by performing electromagnetic field analysis after calculating the switching voltage by circuit analysis from a parameter of a circuit element. Thereafter, each time the parameter of the circuit element is updated, the switching voltage corresponding to the updated gate resistance value by circuit analysis is calculated and the electromagnetic radiation noise corresponding to the updated gate resistance value is estimated. In other words, by substituting the time-consuming electromagnetic field analysis in the design process with circuit analysis that requires less calculation time, number of times of the electromagnetic field analysis is suppressed.

In other words, the present invention is characterized, in supporting design of gate drive circuit, by: acquiring circuit information and a noise target value; calculating a switching voltage of the gate drive circuit based on the circuit information including the gate resistance value; a noise estimation unit estimating an electromagnetic noise to be radiated based on the circuit information and the calculated switching voltage, and modifying the gate resistance value to increase the gate resistance value when the estimated amount of noise is greater than a target range based on the noise target value and to decrease the gate resistance value when the estimated amount of noise is smaller than the target range, and repeating the modification of the gate resistance value, calculation of the switching voltage and the estimation of the electromagnetic noise until the noise amount is within the target range.

Advantageous Effects of Invention

According to the present invention, it is possible to shorten TAT in designing a gate drive circuit.

Brief Description of Drawings

[Figure 1] Figure 1 is a diagram showing a schematic configuration of a power conversion system of an embodiment of the present invention.
[Figure 2] Figure 2 shows a gate drive circuit that controls a semiconductor element in the embodiment of the present invention.
[Figure 3] Figure 3 is a diagram showing a trade-off relationship between the electromagnetic radiation noise and the switching loss.
[Figure 4] Figure 4 is a schematic diagram of a design support device for a gate drive circuit in an embodiment of the present invention.
[Figure 5] Figure 5 is a diagram showing a flow in designing a gate resistance value of an embodiment of the present invention.

Description of Embodiments

The present invention relates to a design support device and a design support method of a gate drive circuit. Hereafter, with reference to the accompanying drawings, the embodiments of the present invention will be described. However, it should be noted that the present embodiments merely show one example to implement the present invention, and do not confine the technical scope of the present invention. Further, in the drawings, same reference numbers are adhered to common structures.

<Electromagnetic radiation noise and switching loss in power conversion system>

First, a mechanism in which the electromagnetic radiation noise and the switching loss that constitutes the background the present invention are generated, and the relationship therebetween, will be explained.

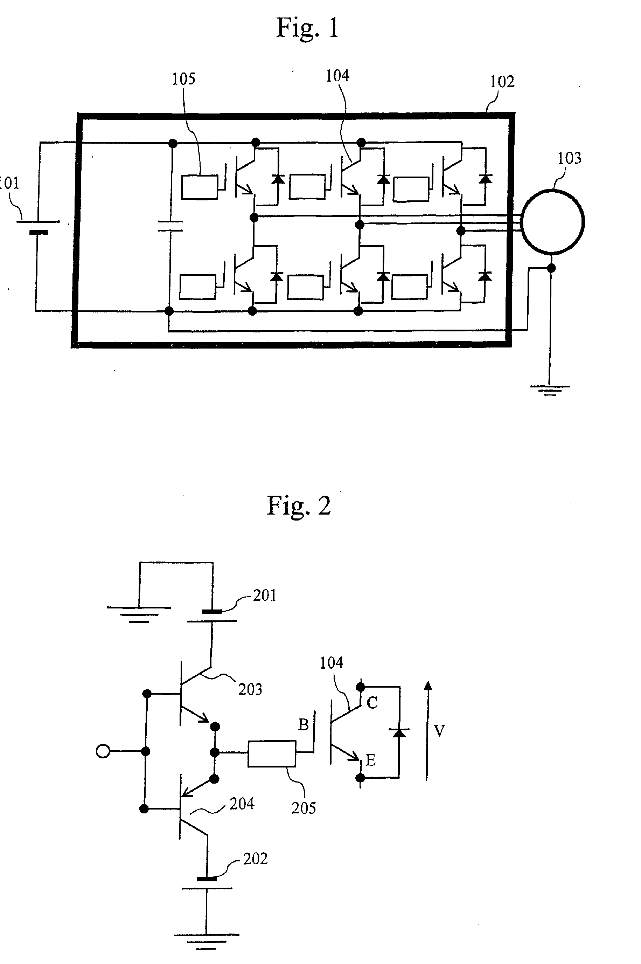

Figure 1 is a diagram showing a schematic configuration of a power conversion system of an embodiment of the present invention. The power conversion system comprises a power supply 101 that provides an input power, a power converter 102 that generates a desired output power by converting the input power, and a load 103 controlled by the power converter 102. The power converter 102 comprises a plurality of semiconductor elements 104 that flow a current to the load 103, a gate drive circuit 105 that turns the semiconductor element 104 ON or OFF. The gate drive circuit 105 switches the semiconductor element 104 by changing the gate voltage of the semiconductor element 104. As the semiconductor element 104, for example, Insulated Gate Bipolar Transistor (IGBT), a Metal-Oxide-Semiconductor Field-Effect Transistor (MOSFET), and a gate turn-off thyristor are used in many cases.

Sudden changes in the switching voltage and switching current cause an electromagnetic radiation noise. In order to decrease the electromagnetic radiation noise, it is necessary to lower the temporal change rates of the switching voltage and switching current by controlling the switching of semiconductor element 104 with the gate drive circuit 105. However, where the temporal change rates of the switching voltage and switching current are reduced, a time for switching becomes longer, and therefore the switching loss becomes large.

Figure 2 is a gate drive circuit that controls a semiconductor element in the embodiment of the present invention. The gate drive circuit comprises power supplies 201 and 202 that provide gate voltages, switching elements 203 and 204 that switch the gate voltages, a gate resistance 205 that lowers a temporal change rate of a switching voltage, and a semiconductor element 104 that flows a current to a load, such as a motor. In accordance with the switching of the semiconductor element 104, the switching voltage fluctuates. This voltage fluctuation generates a noise current in a casing or wiring with the power converter 102, the parasitic capacitance of, the load 103, and the cable, etc. as channel. As the value of the gate resistance 205 is made large, the temporal change rate of the switching voltage decreases and the electromagnetic radiation noise becomes small.

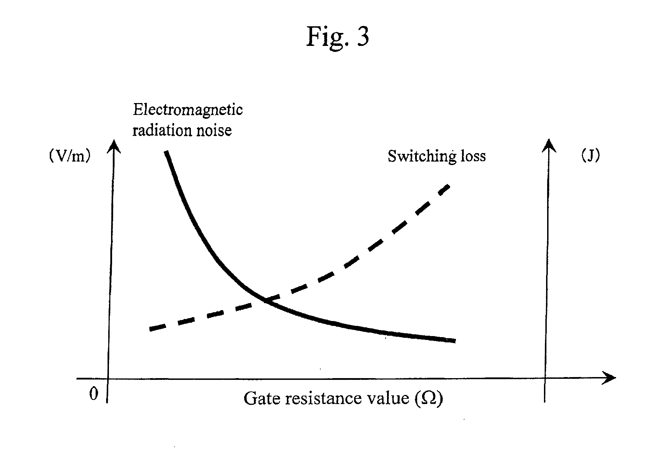

Figure 3 is a diagram showing a relationship among the gate resistance value, an electromagnetic radiation noise of an arbitrary frequency band, and a switching loss. Although as the gate resistance value increases, there is such an advantage that the temporal change rate of the switching voltage lowers, and the electromagnetic radiation noise becomes small, there is a disadvantage that the switching loss increases. Contrarily, where the gate resistance value is made small, there is an advantage that the temporal change rate of the switching voltage increases, and the switching loss becomes small, while there is a disadvantage that the electromagnetic radiation noise increases.

<Principle of Estimating Electromagnetic Radiation Noise>

Next, the principle of estimating the electromagnetic radiation noise used for shortening TAT in designing the circuit of the present invention will be explained.

It is known that, in general, a noise source (S), a dissemination channel (P) and an antenna (A) are the factors that change an electromagnetic radiation noise (E). Replacing these with the elements in the gate drive circuit of the present invention, P and A are determined by the casing of the power converter, the load and the cable that connects the power converter and the load. Since they are determined by the factors other than the gate drive circuit of the present invention, here it is assumed that the state is an ideal state, or unchangeable. On the other hand, S corresponds to the switching voltage that causes induction of the noise current and rapidly changes by the switching of the semiconductor element, and can be controlled by the gate drive circuit.

Hereafter, a principle of estimating the electromagnetic radiation noise will be explained in which, since P and A are permanent on suppressing the electromagnetic radiation noise E, it is premised that the switching voltage S is adjusted by the gate resistance.

When the frequency spectrum of the switching voltage is V(V), the frequency spectrum of a noise current induced by V is I(A) and impedance in the channel of the noise current is Z(Ω), the following relationship establishes.

[Formula 1]

$$V = Z \times I \qquad (1)$$

Here, Z in the channel of the noise current is a constant determined by the factors other than the gate drive circuit, such as the casing of the power converter, the load, and the cable that connects the power converter and the load. Therefore, it is understood that V and I are in a linear relationship.

Next, if the antenna A through which the noise current flows is approximated as a set of small dipoles, an electromagnetic radiation noise generated from the power conversion system of the present invention is equal to superposition of the electromagnetic waves noise generated from each of the small dipoles. From this fact, when the frequency spectrum of the electromagnetic radiation noise generated when a noise current of frequency spectrum I(A) flows through a small dipole dl is E(V/m), the following relationship is derived from Maxwell's equations.

[Formula 2]

$$E = \eta_0 I f \sin\theta dl / (2rc) \qquad (2)$$

Here, $\eta_0$ is a characteristic impedance of a space, c is the speed of light, f is a frequency of the noise current, r is the distance to the observation point from the micro space, θ is an angle formed by the small dipoles and the observation point. These are all constants. Therefore, it is understood that E and I are in a linear relationship.

From Formula (1) and Formula (2), it is understood that the frequency spectrum E of the electromagnetic radiation noise and the frequency spectrum V of the switching voltage are in a linear relationship. Accordingly, when the frequency spectrum of the switching voltage at a gate resistance value is V, the frequency spectrum of the electromagnetic radiation noise generated by V is E, and the frequency spectrum of the switching voltage at the time when the gate resistance value is updated is V', and the frequency spectrum of the electromagnetic radiation noise generated by V', is E', Formula (1) and Formula (2) can be rewritten as in the following.

[Formula 3]

$$E' = E \times V' / V \qquad (3)$$

In other words, when, after calculating the frequency spectrum V of the switching voltage from a gate resistance value by circuit analysis, frequency spectrum E of the electromagnetic radiation noise is obtained by performing the electromagnetic field analysis only once, thereafter it is only necessary to calculate the frequency spectrum V' of the switching voltage by circuit analysis each time the gate resistance value is updated based on the updated gate resistance value, it is possible to estimate frequency spectrum E' of an electromagnetic radiation noise from Formula (3). In other words, there is no need to repeat electromagnetic field analysis each time the gate resistance value is updated and it is possible to markedly decrease the design time until the gate resistance value is determined.

Since the impedance Z in the channel of the noise current is a constant determined in accordance with the channel of the noise current, Formula (3) establishes even if the gate resistance value is changed. That is, Z is invariant against varying of the gate resistance. This is because a dominant noise current is distributed in the casing of the power converter, the load and the cable that connects the power converter and the load, etc. and the noise current distributed in the gate drive circuit is negligible.

<Design Support Device of Gate Drive Circuit>

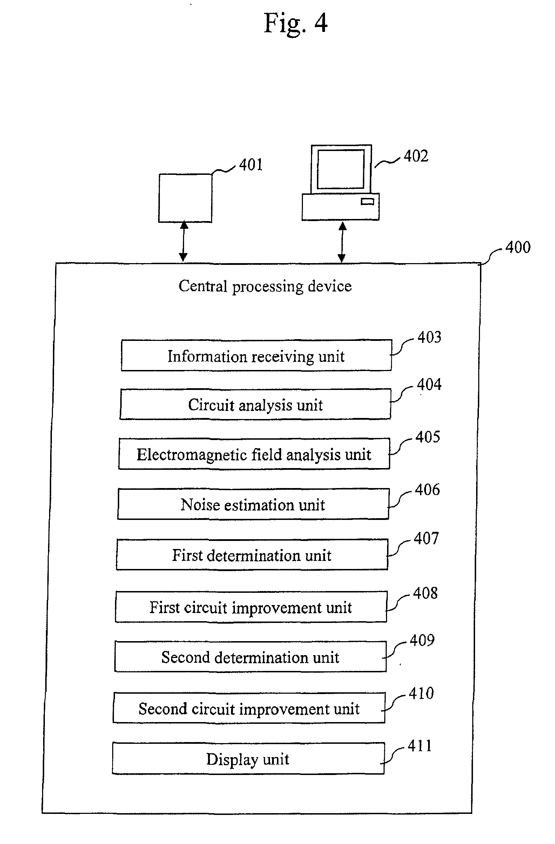

Figure 4 is a schematic diagram of a design support device of a gate drive circuit of an embodiment of the present invention.

The design support device comprises a central processing device 400, a storage device 401 and I/O unit 402. The central processing device 400 comprises information receiving unit 403 that receives information including a circuit parameter for preparing an equivalent circuit, a circuit analysis unit 404 that executes circuit analysis by using the equivalent circuit, an electromagnetic field analysis unit 405 that executes electromagnetic field analysis with the switching voltage wave form calculated by the circuit analysis unit as a noise source, a noise estimation unit 406 that estimates an electromagnetic radiation noise from Formula (3), a first determination unit 407 that determines whether the electromagnetic radiation noise is within a target value, a first circuit improvement unit 408 that adjusts the circuit parameter to suppress the noise in response to the result of the first determination unit, a second determination unit 409 that determines whether the electromagnetic radiation noise can be approximated to the target value, a second circuit improvement unit 410 that adjusts the circuit parameter to maximize noise in response to the result of the second determination unit and a display unit 411 for displaying the optimized gate drive circuit.

The elements of information receiving unit 403 to the display unit 411 may be modularized or may be implemented by storing a program that implements an algorithm of the gate drive circuit design method in the storage device 401 and by causing the central processing device 400 to operate based on the program.

<Gate Drive Circuit Design Method>

By executing the program that implements an algorithm of the gate drive circuit design method stored in the storage device, on the central processing device 400 with the configuration of Figure 4, designing of the gate drive circuit is performed. Hereafter, a method of designing the gate drive circuit is described that minimizes the switching loss by maximizing the electromagnetic radiation noise up to a target value by using a principle of estimating electromagnetic radiation noise. Here, the description will be given with the case of the gate resistance value as an example.

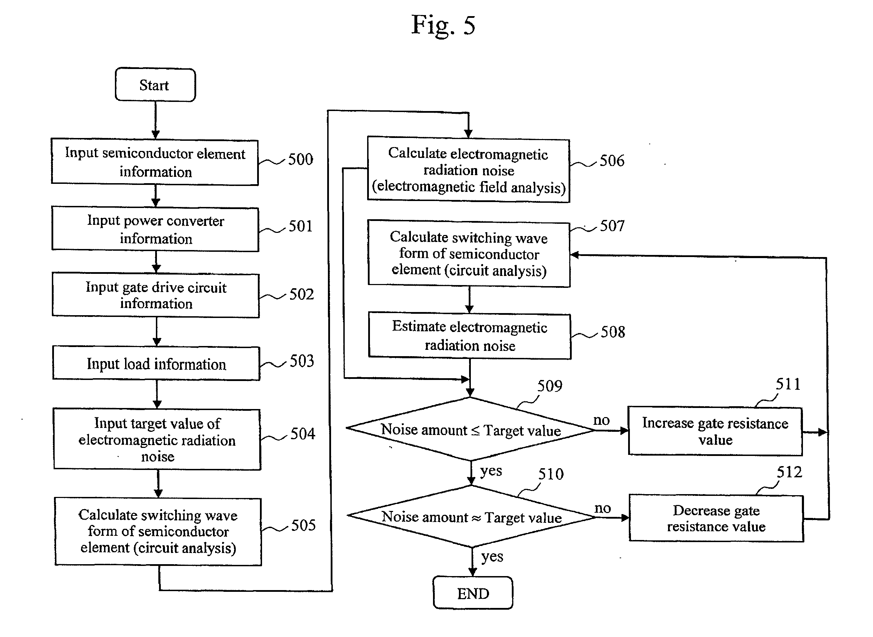

Figure 5 is a diagram that shows a design flow of the gate resistance value of the embodiment of the present invention.

In designing the gate resistance value of the embodiment of the present invention, an electromagnetic radiation noise is obtained by performing electromagnetic field analysis only once after calculating the switching voltage by circuit analysis from the gate resistance value. Thereafter, each time the gate resistance value is updated, the electromagnetic radiation noise is estimated by only calculating the switching voltage corresponding to the updated gate resistance value by circuit analysis. This is a feature of the embodiment of the present invention. In other words, by substituting the time-consuming electromagnetic field analysis in a design process with circuit analysis that spends little calculation time, performing the electromagnetic field analysis is suppressed to one time.

In step 500, the information receiving unit 403 receives semiconductor element information including outer shape information of the semiconductor element information, the number of semiconductor elements, electric characteristics and the equivalent circuit input by the user from the I/O unit 402.

In step 501, the information receiving unit 403 receives power converter information including information on the construction/shape of the power converter on which the semiconductor element is mounted and an equivalent circuit input by the user through the I/O unit 402.

In step 502, the information receiving unit 403 receives the gate drive circuit information including prototype circuit scheme of the gate drive circuit and design initialization parameters including circuit constants input by the user through the I/O unit 402. The gate drive circuit information includes a gate resistance value.

In step 503, the information receiving unit 403 receives load information including the information on construction/shape of the load and an equivalent circuit input by the user through the I/O unit 402.

In step 504, the information receiving unit 403 receives a target value of the electromagnetic radiation noise for each frequency band input by the user through the I/O unit 402. This value is a value determined by the user from prohibition value specified by EN standard and an international standard. In general, when the electromagnetic radiation noise is equal to or less than the target value, malfunction of an electromagnetic device due to noise will not be generated.

In step 505, the circuit analysis unit 404 prepares the equivalent circuit of the whole device based on the inputs in steps 501-504, and performs calculation of switching voltage wave form of the semiconductor element by circuit analysis. For this circuit analysis, a circuit analysis simulator such as an OrCAD(R) is employed.

In step 506, the electromagnetic field analysis unit 405 performs electromagnetic field analysis with the switching voltage wave form calculated in step 505 as a noise source to obtain an electromagnetic radiation noise. For this electromagnetic field analysis, electromagnetic field analysis simulators such as the HFSS(R) or Micro Strips(R) are employed. However, where there is a problem in calculation time or precision in electromagnetic field analysis, at least a pair of observed values of the electromagnetic radiation noise and the switching voltage wave form may be input to obtain the electromagnetic radiation noise.

In step 507, the circuit analysis unit 404 calculates the switching voltage wave form of the semiconductor element corresponding to the circuit scheme and the circuit constants of the gate drive circuit in the same way as step 505.

In step 508, the noise estimation unit 406 calculates the estimated value E' of the electromagnetic radiation noise by using Formula (3). Here, the frequency spectrum of the switching voltage calculated in step 505 is V, a radiation noise spectrum obtained in step 506 is E, a frequency spectrum of the switching voltage calculated in step 507 is V', an electromagnetic radiation noise spectrum, with V' as the noise source, is E'.

In step 509, the first determination unit 407 determines whether the electromagnetic radiation noise is equal to or less than the target value. Where the electromagnetic radiation noise is equal to or less than the target value, the process proceeds to step 510, and where it is not equal to or less than the target value, the process proceeds to step 511. The determination is performed by comparing the electromagnetic radiation noise generated by a current gate resistance value with the target value of the electromagnetic radiation noise. The comparison is performed based on whether the target difference value $E_{min}$ is a negative value by using the following formula. If $E_{min}$ is not a negative value, the value is equal to or less than the target value, and if $E_{min}$ is a negative value, the value is not equal to or less than the target value.

[Formula 4]

$$E_{min} = \min_f(E_{LIMIT}(f) - E(f)) \qquad (4)$$

Here, f is a frequency, $E_{LIMIT}(f)$ is a frequency spectrum of the electromagnetic radiation noise of the target value in frequency f, E(f) is a frequency spectrum of the electromagnetic radiation noise in frequency f corresponding to the gate drive circuit. By these processes, the electromagnetic radiation noise can be suppressed up to a target value.

In step 510, the second determination unit 409 determines whether the electromagnetic radiation noise generated with the current gate resistance value is approximated to the target value. Where it is determined that the electromagnetic radiation noise is approximated to the target value, the flow is terminated with the current gate resistance value being optimal. Where it is not determined that the electromagnetic radiation noise is approximated to the target value, the process proceeds to step 512. The determination is performed based on whether $E_{min}$ of Formula (4) is, for example, within -5% of target value. By maximizing the electromagnetic radiation noise to the limit of the target value in this process after suppressing the electromagnetic radiation noise to equal to or less than the target value in step 509, it is possible to minimize the switching loss. Therefore, it is possible to omit the process of calculating the switching loss from the design process.

In step 511, where it is not determined in step 509 that the electromagnetic radiation noise is equal to or less than the target value, the first circuit improvement unit 408 improves the gate resistance value so as to increase the gate resistance value. By causing the gate resistance value to increase, the temporal change rate of the switching voltage is made moderate, and the generation of the electromagnetic radiation noise is to be suppressed. However, since the period by which ON and OFF of the semiconductor element is switched becomes long, the switching loss increases. Where the current gate resistance value is R, an arbitrary positive number designated by the user is $\alpha$, and the target difference value calculated in step 509 is E . , the gate resistance value after improvement, R', can be calculated by the following formula:

[Formula 5]

$$R' = R - \alpha \times E_{min} \qquad (5)$$

In step 512, where it is not determined that the electromagnetic radiation noise is approximated to the target value in step 510, the second circuit improvement unit 410 improves the gate resistance value in such a manner as to decrease the gate resistance value. By decreasing the gate resistance value, the temporal change rate of the switching voltage is made sharp, and the switching loss is decreased. However, since the period by which ON and OFF of the semiconductor element is switched becomes short, the electromagnetic radiation noise increases. The gate resistance value after improvement is calculated by using Formula (5) in the same way as step 511.

In steps 511 and 512, where the gate resistance value is updated, since the temporal change rate of switching voltage varies, the switching voltage of the semiconductor element should be again obtained. Therefore, the process returns to step 507. In this way, it is necessary to repeat steps 507-512 until the electromagnetic radiation noise can be equal to or less than the target value and approximated to the target value. All of the calculations repeated there are the circuit analyses.

Here, the flow until determination of the gate resistance value in Figure 2 is explained. However, also in those gate drive circuits that employ other circuit schemes, it is possible to determine the optimal parameters similarly, as long as a circuit element that can be a factor of fluctuating in the switching voltage temporal change rate and that is the noise source of the electromagnetic radiation noise. For example, the circuit element may be a coil, a capacitor and a light filter, etc.

<Conclusion>

In the design support method of a gate drive circuit and the device thereof in the embodiment of the present invention, an electromagnetic radiation noise is obtained by performing electromagnetic field analysis only once after calculating the switching voltage by circuit analysis from a gate resistance value. Thereafter, each time the gate resistance value is updated, by only calculating the switching voltage corresponding to the updated gate resistance value by circuit analysis, the electromagnetic radiation noise corresponding to the updated gate resistance value is estimated.

This eliminates the necessity to repeat the electromagnetic field analysis each time the gate resistance value is updated, and it is possible to markedly decrease the design time until the gate resistance value is determined.

In this case, where there is a problem in time and precision of the electromagnetic field analysis, where the electromagnetic radiation noise is estimated based on at least a pair of the observed values of the switching voltage and the electromagnetic radiation noise, it is possible to further cut time for designing, by the time for electromagnetic field analysis.

Further, the electromagnetic radiation noise obtained by the electromagnetic field analysis or the electromagnetic radiation noise estimated by Formula (3) are compared with the target value, where it is not equal to or less than the target value, the gate resistance value is increased. This enables suppressing the electromagnetic radiation noise to equal to or less than the target value. In this case, it is determined that whether it is possible to approximate the electromagnetic radiation noise obtained by the electromagnetic field analysis or the electromagnetic radiation noise estimated by Formula (3) to the target value, and where approximation is impossible, the gate resistance value may be decreased. Accordingly, it is possible to maximize the electromagnetic radiation noise at a value that is equal to or less than the target value. Therefore, it is possible to minimize the switching loss. That is, since, by performing the optimization of the electromagnetic radiation noise, the switching loss is optimized at the same time, it is possible to omit calculation of the switching loss from the design process, and it is possible to further decrease the time for designing. In other words, it is possible to shorten TAT in designing a gate drive circuit that reconciles suppressing the electromagnetic radiation noise and reducing switching loss.

Reference Signs List

| | |
|---|---|
| 400 | central processing device |
| 401 | storage device |
| 402 | I/O unit |
| 403 | information receiving unit |
| 404 | circuit analysis unit |
| 405 | electromagnetic field analysis unit |
| 406 | noise estimation unit |
| 407 | first determination unit |
| 408 | first circuit improvement unit |
| 409 | second determination unit |
| 410 | second circuit improvement unit |
| 411 | display unit |

**Claims**

1.  A design support device of a gate drive circuit, comprising:

    an information receiving unit that acquires circuit information and a noise target value;
    a circuit analysis unit that calculates a switching voltage of the gate drive circuit based on the circuit information including a gate resistance value;
    a noise estimation unit that estimates an electromagnetic noise to be radiated based on the circuit information and the calculated switching voltage; and
    a circuit improvement unit that modifies the gate resistance value to increase the gate resistance value when the estimated amount of noise is greater than a target range based on the noise target value, and to decrease the gate resistance value when the estimated amount of noise is smaller than the target range,
    wherein the design support device of the gate drive circuit repeats modification of the gate resistance value, calculation of the switching voltage and estimation of the electromagnetic noise until the noise amount is within the target range.

2.  The design support device according to claim 1, wherein the circuit information includes information of the semiconductor element, information of the power converter on which the semiconductor element is mounted and information of the gate drive circuit.

3.  The design support device according to claim 1 or 2, wherein an upper limit of the target range is the target value.

4.  A design support method of a gate drive circuit, comprising;

    an information receiving step, by an information receiving unit, of acquiring circuit information and a noise target value;
    a circuit analyzing step, by a circuit analysis unit, of calculating a switching voltage of the gate drive circuit based on the circuit information including the gate resistance value;
    a noise estimation step, by a noise estimation unit, of estimating an electromagnetic noise to be radiated based on the circuit information and the calculated switching voltage; and
    a circuit improvement step, by circuit improvement unit, of modifying the gate resistance value to increase the gate resistance value when the estimated amount of noise is greater than a target range based on the noise target value and to decrease the gate resistance value when the estimated amount of noise is smaller than the target range;
wherein the circuit analyzing step, the noise estimation step and the circuit improvement step are repeated until the noise amount is within the target range.

# Fig. 1

# Fig. 2

# Fig. 3

# Fig. 4

Central processing device

Information receiving unit — 403

Circuit analysis unit — 404

Electromagnetic field analysis unit — 405

Noise estimation unit — 406

First determination unit — 407

First circuit improvement unit — 408

Second determination unit — 409

Second circuit improvement unit — 410

Display unit — 411

# Fig. 5

```
                          Start

                            │
                            ▼
              ┌──────────────────────────┐
              │ Input semiconductor element│ ～500
              │      information          │
              └──────────────────────────┘
                            │
                            ▼
              ┌──────────────────────────┐
              │   Input power converter   │ ～501
              │      information          │
              └──────────────────────────┘
                            │
                            ▼
              ┌──────────────────────────┐
              │  Input gate drive circuit │ ～502
              │      information          │
              └──────────────────────────┘
                            │
                            ▼
              ┌──────────────────────────┐
              │   Input load information  │ ～503
              └──────────────────────────┘
                            │
                            ▼
              ┌──────────────────────────┐
              │   Input target value of   │ ～504
              │  electromagnetic radiation│
              │          noise            │
              └──────────────────────────┘
                            │
                            ▼
              ┌──────────────────────────┐
              │   Calculate switching wave│ ～505
              │   form of semiconductor   │
              │   element (circuit analysis)│
              └──────────────────────────┘
```

```
              ┌──────────────────────────┐
              │  Calculate electromagnetic│ ～506
              │      radiation noise      │
              │(electromagnetic field analysis)│
              └──────────────────────────┘
                            │
                            ▼
              ┌──────────────────────────┐
              │   Calculate switching wave│ ～507
              │   form of semiconductor   │
              │   element (circuit analysis)│
              └──────────────────────────┘
                            │
                            ▼
              ┌──────────────────────────┐
              │  Estimate electromagnetic │ ～508
              │      radiation noise      │
              └──────────────────────────┘
                            │
                            ▼
                           509                          511
              ◇ Noise amount ≤ Target value ◇ ──no──▶ ┌────────────────────┐
                            │                          │ Increase gate resistance│
                           yes        510              │        value        │
                            ▼                          └────────────────────┘
              ◇ Noise amount ≈ Target value ◇ ──no──▶ ┌────────────────────┐  512
                            │                          │  Decrease gate     │
                           yes                         │  resistance value  │
                            ▼                          └────────────────────┘
                          END
```

EP 2 579 172 A1

**INTERNATIONAL SEARCH REPORT**

| International application No. |
| --- |
| PCT/JP2011/061611 |

A. CLASSIFICATION OF SUBJECT MATTER
*G06F17/50*(2006.01)i, *H02M1/08*(2006.01)i

According to International Patent Classification (IPC) or to both national classification and IPC

B. FIELDS SEARCHED

Minimum documentation searched (classification system followed by classification symbols)
G06F17/50, H02M1/08

Documentation searched other than minimum documentation to the extent that such documents are included in the fields searched
Jitsuyo Shinan Koho          1922-1996    Jitsuyo Shinan Toroku Koho    1996-2011
Kokai Jitsuyo Shinan Koho    1971-2011    Toroku Jitsuyo Shinan Koho    1994-2011

Electronic data base consulted during the international search (name of data base and, where practicable, search terms used)
IEEE Xplore, CiNii, JSTPlus(JDreamII)

C. DOCUMENTS CONSIDERED TO BE RELEVANT

| Category* | Citation of document, with indication, where appropriate, of the relevant passages | Relevant to claim No. |
| --- | --- | --- |
| Y | JP 2009-223885 A  (Hitachi, Ltd.),<br>01 October 2009 (01.10.2009),<br>paragraphs [0082] to [0096]; fig. 21 to 25<br>& US 2009/0213558 A1 | 1-4 |
| Y | JP 2002-199700 A  (Meidensha Corp.),<br>12 July 2002 (12.07.2002),<br>paragraphs [0002] to [0011]<br>(Family: none) | 1-4 |
| A | JP 2009-225631 A  (Toyota Motor Corp.),<br>01 October 2009 (01.10.2009),<br>paragraphs [0026] to [0032]; fig. 3 to 5<br>& US 2011/0007536 A      & EP 2256917 A1<br>& WO 2009/116360 A1      & KR 10-2010-0121701 A<br>& CN 101978587 A | 1-4 |

[X] Further documents are listed in the continuation of Box C.    [ ] See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>22 July, 2011 (22.07.11) | Date of mailing of the international search report<br>02 August, 2011 (02.08.11) |
| --- | --- |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2011/061611 |

C (Continuation).　DOCUMENTS CONSIDERED TO BE RELEVANT

| Category* | Citation of document, with indication, where appropriate, of the relevant passages | Relevant to claim No. |
| --- | --- | --- |
| A | JP 2006-345635 A  (National Institute of Advanced Industrial Science and Technology), 21 December 2006 (21.12.2006), paragraphs [0039] to [0046]; fig. 8 (Family: none) | 1-4 |
| A | JP 2009-26298 A  (Central Research Institute of Electric Power Industry), 05 February 2009 (05.02.2009), paragraphs [0002] to [0010]; fig. 14 to 15 (Family: none) | 1-4 |

Form PCT/ISA/210 (continuation of second sheet) (July 2009)

**REFERENCES CITED IN THE DESCRIPTION**

**Patent documents cited in the description**

- JP 2009253699 A
- JP 2009071956 A

- JP 2006230166 A